# FASCICULE DE BREVET EUROPEEN

(11) **EP 2 673 817 B1**
(45) Date de publication et mention de la délivrance du brevet: **15.04.2015**
(21) Numéro de dépôt: 12707875.6
(22) Date de dépôt: 07.02.2012
(51) Int. Cl.: H01L 51/42, H01L 51/05, G02F 1/00, G02F 1/01

(54) **AGENCEMENT OPTIMISÉ DE PARTICULES DE TRIAZOLE**
OPTIMIERTE ANORDNUNG VON TRIAZOLPARTIKELN
OPTIMISED ARRANGEMENT OF TRIAZOLE PARTICLES

(30) Priorité: 07.02.2011 FR 1150949
(43) Date de publication de la demande: 18.12.2013
(73) Titulaire: Centre National de la Recherche Scientifique (CNRS), 75794 Paris Cedex 16 (FR)
(72) Inventeur: LETARD, Jean-François, F-33610 Canejean (FR); ETRILLARD, Céline, F-91120 Palaiseau (FR); DOUDIN, Bernard, F-67000 Strasbourg (FR); FARAMARZI, Vina, F-67000 Strasbourg (FR); DAYEN, Jean-François, F-67000 Strasbourg (FR)
(74) Mandataire: Cabinet Plasseraud
(86) Numéro de dépôt international: PCT/FR2012/050259
(87) Numéro de publication internationale: WO 2012/107680

(56) Documents cités:
- US-B1- 6 200 730
- SHI S ET AL: "Study of molecular spin-crossover complex Fe(phen)2(NCS)2 thin films", APPLIED PHYSICS LETTERS, AIP, AMERICAN INSTITUTE OF PHYSICS, MELVILLE, NY, US, vol. 95, no. 4, 29 juillet 2009 (2009-07-29), pages 43303-43303, XP012122503, ISSN: 0003-6951, DOI: 10.1063/1.3192355
- KAHN O ET AL: "Spin-Transition Polymers: From Molecular Materials Toward Memory Devices", SCIENCE, AMERICAN ASSOCIATION FOR THE ADVANCEMENT OF SCIENCE, WASHINGTON, DC; US, vol. 279, no. 5347, 2 janvier 1998 (1998-01-02), pages 44-48, XP002470184, ISSN: 0036-8075, DOI: 10.1126/SCIENCE.279.5347.44

## Description

L'invention concerne le domaine des dispositifs électroniques et notamment le domaine de la photo-conversion et des dispositifs photoélectriques.

La photoconversion est relative soit, en mode émission, à la création de photons par le dispositif électronique soumis à un courant ou à une tension, soit, en mode réception, à la modification des propriétés électriques en présence de photons.

En particulier, deux types de dispositifs de réception sont souvent utilisés : les dispositifs photoélectriques pour lesquels un photon modifie la résistivité et les dispositifs photovoltaïques dans lesquels la réception de photons induit la création d'un courant par le dispositif.

Le premier type de dispositif est utile pour former des capteurs de détection de lumière ou pour adapter un procédé à une luminosité donnée.

Le second type de dispositif peut être utilisé soit comme un capteur de détection de lumière, soit comme générateur de courant ou de tension, par exemple pour alimenter en courant et/ou en tension un réseau électrique ou un autre dispositif électronique.

Ces deux types de dispositifs entrent globalement dans le domaine des dispositifs à matériaux 'intelligents' qui interagissent avec des stimuli externes qui ont, entre autres, des applications dans les domaines de la sécurité et la détection de seuils d'alerte.

Les matériaux connus de l'état de la technique afin de former des dispositifs photoélectriques sont généralement des matériaux semiconducteurs. Ils sont par exemple en matériaux monocristallins tels que du silicium ou de l'arséniure de gallium encore en silicium polycristallin ou en d'autres matériaux amorphes. Pour manipuler ces matériaux et fabriquer des dispositifs, il est généralement nécessaire d'employer les techniques de la microélectronique qui sont coûteuses et difficiles à mettre en place.

D'autres matériaux existent, tels des matériaux à base de colorants. Cependant, cette solution utilise des matériaux rares, du ruthénium par exemple, et nécessite une mousse de nano-particules de dioxyde de titane pour avoir de bons rendements. Il est de plus nécessaire de maintenir le colorant en solution dans un liquide, ce qui peut nécessiter de résoudre des problèmes d'étanchéité et implique de prendre des précautions en cas de gel de la solution liquide.

Encore une autre solution connue est l'usage de matériaux organiques. Ces matériaux sont peu efficaces comparativement aux autres solutions et ils connaissent des risques de re-cristallisation des polymères et des risques de dégradation lors de variations de température.

Un dispositif électronique comportant un film avec un matériau à transition d'état de spin électronique commandé en température recouvrant deux électrodes est décrit par Shi et al (Appl. Phys. Lett. 2009, 95, 043303)

Aucune des solutions connues à ce jour n'est complètement satisfaisante. Il est souhaité des dispositifs ayant un meilleur rendement énergétique ou une meilleure sensibilité ou à coût de conception faible. Ainsi, le monde industriel est en recherche de nouveaux moyens de produire de tels dispositifs.

La présente invention est relative à un dispositif ayant de telles propriétés photoconductrices.

L'invention propose à cet effet un dispositif dont les propriétés varient en fonction de la luminosité. L'invention a trait en particulier à un dispositif électrique comportant deux électrodes séparées l'une de l'autre dans lequel au moins une particule à transition d'état de spin électronique commandé en température est en contact direct avec chacune des deux électrodes. La particule est choisie comme étant de type ionique et comportant un métal de transition qui porte une charge cationique.

De cette manière, la particule en contact avec les deux électrodes a, dans l'obscurité, une conductivité comparable à celle d'un matériau semiconducteur.

Comme la particule a une transition d'état de spin électronique commandé en température, cela signifie qu'en deçà d'une température de transition la particule est de préférence dans un premier état électronique de spin parmi l'état électronique de spin haut et l'état électronique de spin bas et au-delà de cette température de transition, la particule est de préférence dans l'autre des deux états électroniques de spin. En particulier dans un cas préférentiel, en deçà d'une température de transition la particule est dans l'état électronique de spin bas et au-delà de cette température de transition, la particule est dans l'état électronique de spin haut. La température de transition peut avoir des valeurs différentes selon que la transition se fasse en augmentant la température ou en diminuant la température.

Le dispositif permet donc de relier deux électrodes par une particule qui est potentiellement sensible à un changement d'état électronique de spin, ce qui est favorable pour une interaction avec des photons.

La conductivité de la particule varie en fonction d'une intensité lumineuse incidente et en conséquence le dispositif a au moins une propriété électrique qui varie en fonction de l'intensité lumineuse.

Bien qu'il ne soit discuté que d'une particule, on comprend bien que l'invention s'adresse aussi à des dispositifs comportant plusieurs particules en contact direct simultané avec les deux électrodes.

De préférence, la particule est à base d'un composé répondant à la formule :

[Fe(R-Trz)₃](X)ₙ.

Dans laquelle R-Trz est un ligand 1,2,4-triazole portant un substituant R sur l'azote en position 4; X représente au moins un anion; et n est calculé de telle sorte que l'électroneutralité de la formule soit respectée.

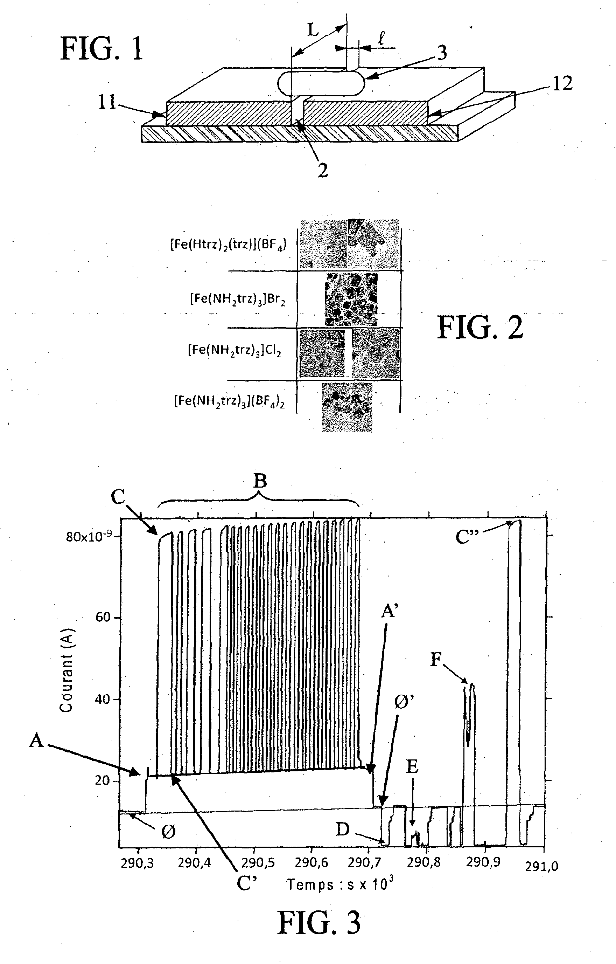

Le substituant R est avantageusement choisi parmi l'ensemble composé de l'hydrogène et des composés H₂N-, R₁-, HR₁N-, et R₁R₂N- où R₁ et R₂ sont des radicaux alkyles. Il est à noter, que dans certains cas, des ligands triazole peuvent ne pas avoir de substituant R, et ils forment alors un anion, connu sous le nom de triazolato. Si certains des ligands triazoles de la particule sont remplacés par un ligand anionique triazolato, ce peut être par exemple pour chacun des composés contenus dans la particule (figure 2), ou pour une partie seulement de ces composés.

Ces particules, par exemple sous la forme d'agrégats de composés majoritairement constitués selon la formule précitée, sont des exemples de particules ayant une transition d'états électroniques de spin commandée en température.

La particule est de préférence une particule nanométrique dont au moins une dimension est nanométrique, comprise entre 700 nm et 30 nm ou 10 nm ou inférieure à 5 nm. Ainsi, il est possible de prévoir un dispositif avec une grande densité d'intégration.

Dans certains modes de réalisation du dispositif selon l'invention, la particule est recouverte de façon dissymétrique par une couche de métal. La couche de métal peut apporter des propriétés optiques, magnétiques, électriques ou chimiques à la particule, ce qui peut modifier les propriétés photo-électriques du dispositif, par exemple en modifiant l'absorption de certaines longueurs d'ondes ou en modifiant le contact électrique entre la particule et l'une et/ou l'autre des électrodes. De plus, si la couche de métal est magnétique ou magnétisable, par exemple en nickel, elle peut être utile pour positionner les particules au niveau de la tranchée selon un mode de réalisation du procédé de l'invention décrit plus bas. On comprendra donc qu'une particule recouverte partiellement de métal magnétique ou magnétisable est une trace de la mise en oeuvre du procédé de fabrication.

Dans un mode de réalisation particulier, le dispositif selon l'invention est apte à fonctionner comme dispositif photoconducteur. Pour cela, dans un mode préférable de réalisation les deux électrodes sont recouvertes par un même métal. Les électrodes ont alors des surfaces en un métal identique et cela facilite l'obtention, pour chaque particule, de fonctions de travail sensiblement identiques avec chacune des deux électrodes.

Dans un autre mode de réalisation particulier, le dispositif selon l'invention est apte à fonctionner comme un dispositif photovoltaïque. Pour cela, dans un mode préférable de réalisation l'une des deux électrodes est recouverte par un premier métal et l'autre des deux électrodes est recouverte par un deuxième métal, différent du premier métal. La particule est donc en contact avec des surfaces en un métal différent pour chaque électrode et cela facilite l'obtention, pour chaque particule, de fonctions de travail différentes avec chacune des deux électrodes. Cette différence des fonctions de travail donne alors des propriétés photovoltaïques au dispositif selon l'invention. La particule, reliée aux électrodes produit alors une tension qui dépend de l'intensité lumineuse incidente.

Aussi bien pour la particule que pour les surfaces des électrodes, le métal est de préférence choisi parmi l'un des éléments de la liste consistant en l'or, le nickel et une structure multicouche or-nickel. En effet, l'or est connu pour sa neutralité chimique et ses propriétés de conduction électrique et le nickel peut apporter des propriétés magnétiques à la particule ou aux électrodes. On peut aussi utiliser de l'aluminium, du ruthénium ou d'autres métaux. Une structure multicouche permet d'apporter une fonction propre à un premier métal, par exemple le nickel à la particule et/ou aux électrodes tout en ayant une surface en un deuxième métal, par exemple de l'or. On peut ainsi créer une particule qui bien que portant une fonction magnétique générée par le nickel ne réagit pas forcément chimiquement par sa couche de métal, ou on peut créer une électrode en nickel dont la surface est en or.

De préférence, les électrodes sont séparées par une tranchée imposant une distance inférieure ou sensiblement égale à 100 nanomètres entre les deux électrodes. Ainsi, il est possible de créer un dispositif avec une grande densité d'intégration. De plus cette dimension est généralement plus faible que les dimensions des particules.

Les électrodes sont séparées par une tranchée et sont en vis-à-vis sur une distance linéique qui peut être comprise entre quelques micromètres et quelques mètres. Il est ainsi possible de moduler la densité d'intégration du dispositif et d'adapter la distance linéique au nombre de particules présentes en contact direct simultané avec les deux électrodes.

Les deux électrodes ont des hauteurs, définies perpendiculairement à un plan principal commun aux deux électrodes, qui peuvent être avantageusement différentes l'une de l'autre. Cette différence de hauteur rend possible une variété de contacts électriques entre la particule et les électrodes.

Le dispositif selon l'invention, apte à fonctionner comme un dispositif photoélectrique et apte à changer de propriétés photoélectriques à partir d'une température prédéterminée, peut avantageusement être tel que les particules à transition d'état électronique de spin sont choisies parmi les particules à transition d'état de spin électronique commandée en température dont la transition de spin a lieu autour de la température spécifiée. La transition d'état électronique de spin commandée en température permet de modifier les propriétés de la particule. Dans certains cas avantageux, cette modification des propriétés induit une modification des propriétés optiques ou électriques. Par exemple, il est possible que la transition d'état électronique de spin induise une modification de l'absorption lumineuse. Il est donc possible de fournir un dispositif dont la propriété photoélectrique change lorsque l'on atteint une température donnée. Ce peut être utile si l'on veut un contrôle en température, ou pour limiter le vieillissement du dispositif lorsque la température devient trop forte.

L'invention concerne aussi un procédé de fabrication d'un dispositif selon l'invention. Ledit procédé comporte avantageusement les étapes successives suivantes :
a) fourniture de deux électrodes métalliques sur un substrat séparées l'une de l'autre par une tranchée,
b) dépôt d'au moins une particule à transition d'état de spin électronique commandée en température de façon à ce qu'elle soit en contact direct simultané avec les deux électrodes.

Le dépôt de la particule se fait de préférence sous la forme d'une application localisée d'une solution liquide comportant la particule en solution ionique. Ensuite une évaporation de la solution liquide a avantageusement lieu pour laisser la particule sur le dispositif, et retirer la solution liquide. La particule étant de type ionique comportant un métal de transition qui porte une charge cationique, l'électroneutralité de la phase liquide est assurée par un contre-ion anionique. Le dépôt sous la forme d'une solution liquide a l'avantage de rendre possible un dépôt de particule sur les électrodes et de façon localisée sans la détériorer. L'évaporation de la solution liquide est un moyen efficace pour ne plus laisser en surface des électrodes que les particules et les contre-ions.

Il est à noter que l'étape b) peut être remplacée par une autre étape de formation des particules, par exemple par croissance sur les électrodes.

Le procédé selon l'invention peut comporter, après l'étape b), l'application d'une tension entre les deux électrodes. La tension appliquée est suffisamment élevée pour réduire les résistances d'accès entre les électrodes et la particule mais suffisamment faible pour ne pas détruire la particule ou la tranchée séparant les électrodes. Il est ainsi procédé à une soudure en tension. Le contact électrique entre la particule et l'une et/ou l'autre des deux électrodes est amélioré de façon à obtenir une meilleure conductance du dispositif.

La tension appliquée est avantageusement comprise entre 0,5 volts et 5 volts. Cette gamme de tension est généralement suffisamment élevée pour réduire les résistances d'accès entre les électrodes et la particule mais suffisamment faible pour ne pas détruire la particule ou la tranchée séparant les électrodes.

Selon un autre mode avantageux du procédé de réalisation d'un dispositif selon l'invention, pour lequel les électrodes comportent au moins un métal magnétisable, on prévoit avantageusement préalablement à l'étape b) :
- une étape dans laquelle on recouvre partiellement la particule à déposer à l'étape b) d'une couche de métal ayant des propriétés magnétiques,
- et une étape de magnétisation des électrodes au moyen d'une application d'un champ magnétique au niveau des deux électrodes.

De plus, de préférence, l'étape b) comporte, entre le dépôt de la solution liquide et son évaporation, une étape d'organisation des particules au niveau de la tranchée séparant les électrodes au moyen d'une application d'un champ magnétique au niveau des deux électrodes.

Les étapes de magnétisation et d'organisation créent, au moyen de l'application du champ magnétique un gradient de champ magnétique au niveau de la tranchée qui sépare les deux électrodes. La particule est dans la goutte de solution liquide et elle peut ainsi se déplacer librement. Comme elle a été préalablement métallisée par une couche de métal ayant des propriétés magnétiques, elle est attirée préférentiellement par le gradient de champ magnétique. La particule vient donc s'auto-positionner au niveau de la tranchée, ce qui augmente les chances que la particule soit, après évaporation de la solution liquide, en contact direct simultané avec les deux électrodes. De façon avantageuse, l'étape d'organisation des particules permet, en attirant préférentiellement les particules au niveau de la tranchée, d'augmenter la densité de particules présentes au niveau de la tranchée par rapport à un procédé sans étape d'organisation.

D'autres caractéristiques et avantages de l'invention apparaîtront à l'examen de la description détaillée ci-après, et des dessins annexés sur lesquels :
- la figure 1 représente schématiquement un dispositif selon l'invention comportant une particule en contact direct simultané avec deux électrodes ;
- la figure 2 est un tableau représentant certaines formules de composé pouvant être utilisés dans un dispositif selon l'invention ainsi que des formes possibles pour des particules basées sur ces composés ;
- la figure 3 est un diagramme illustratif de la conductance d'un dispositif selon l'invention en fonction du temps lorsque l'on varie une intensité lumineuse incidente ;
- la figure 4 est un diagramme représentant la résistance d'un film d'or en fonction du temps lorsque l'on varie une intensité lumineuse incidente ;
- les figures 5A et 5B sont des photographies obtenues par microscope électronique à balayage d'un dispositif selon l'invention ;
- la figure 6 est une photographie obtenue par microscope électronique à balayage d'un dispositif selon l'invention dans lequel les particules sont ordonnées au niveau de la tranchée ;
- la figure 7 est une photographie obtenue par microscope électronique à balayage d'une particule partiellement métallisée ;
- la figure 8 est un diagramme 1 de V représentant les propriétés photovoltaïques d'un mode de réalisation d'un dispositif selon l'invention ;
- les figures 9A et 9B représentent schématiquement deux variantes du dispositif selon l'invention ;
- la figure 10 représente schématiquement un dispositif de test utilisé pour évaluer les performances du dispositif selon l'invention ;
- les figures 11A à 11C illustrent schématiquement un procédé selon l'invention ;
- la figure 12 illustre schématiquement une étape avantageuse du procédé selon l'invention appelée soudure en tension ;
- la figure 13 est un diagramme représentant la conductance d'un dispositif selon l'invention en fonction du temps, avant et après application de l'étape de soudure en tension ;
- les figures 14A à 14E illustrent schématiquement un procédé pour métalliser partiellement des particules pour un dispositif selon l'invention ;
- les figures 15A et 15B sont des photographies obtenues par microscope électronique à balayage illustrant le procédé pour métalliser partiellement des particules ;
- les figures 16A à 16D illustrent schématiquement une étape avantageuse du procédé selon l'invention dans laquelle les particules sont positionnées au niveau de la tranchée ;
- les figures 16C' et 16D' illustrent une variante de l'étape du procédé selon l'invention dans laquelle les particules sont positionnées au niveau de la tranchée ;
- la figure 17 est une photographie obtenue par microscope électronique à balayage d'un dispositif obtenu en utilisant cette étape avantageuse ;
- la figure 18 représente schématiquement une variante de cette étape avantageuse dans laquelle les deux électrodes ont une hauteur différente.

On se réfère tout d'abord à la figure 1 sur laquelle est représenté de façon schématique un dispositif selon l'invention. Le dispositif électrique 1 selon l'invention comporte deux électrodes 11 et 12 séparées l'une de l'autre par une tranchée 2. Au moins une particule à transition d'état de spin électronique 3 commandée en température, dite « particule » dans la suite de la description, est en contact direct simultané avec les deux électrodes 11, 12. Une telle particule sera par la suite dénommée «particule active ». Le terme « particule » désignera toute particule dont on peut commander une transition de l'état de spin électronique en variant la température, de façon indépendante du dispositif, tandis que le terme « particule active » désignera toute particule en contact direct simultané avec les deux électrodes. De préférence plusieurs particules actives sont prévues dans les dispositifs selon l'invention. Mais il est possible qu'il n'y ait qu'une seule particule active.

Les particules 3 sont de type ionique, ce qui signifie que les particules 3 sont constituées de chaînes de molécules qui incluent des métaux de transition portant une charge ionique positive. Des contre-ions permettent de former un composé ionique dont l'électro-neutralité est respectée en apportant une charge ionique négative. Les particules 3 peuvent être des polymères de coordination.

Dans un cas préférentiel, les particules 3 ont au moins une dimension nanométrique, c'est-à-dire inférieure à un micromètre, et par exemple supérieure à 1 nm ou 5 nm ou 10 nm. Un exemple avantageux est d'utiliser des particules 3 de dimensions comprises entre 30 nanomètres (nm) et 700 nm.

Les électrodes 11, 12 sont conductrices et sont séparées par une tranchée 2. De préférence, les deux électrodes 11, 12 sont séparées l'une de l'autre par une distance sensiblement constante appelée ci après « largeur 1 » de la tranchée 2.

De préférence, la largeur 1 de la tranchée 2 a une valeur inférieure à une dimension desdites particules 3. Typiquement, la largeur 1 de la tranchée peut avoir une valeur très inférieure à deux dimensions des particules 3. Par exemple, cette valeur peut être inférieure d'un facteur 2, 3 ou plus à deux dimensions des particules 3. Ainsi, dans un cas particulier, la tranchée 2 séparant les deux électrodes 11, 12 peut avoir une largeur 1 comprise entre 50 nm et 500 nm, ou entre 70 nm et 100 nm. On comprendra que la largeur de la tranchée 2 peut être adaptée aux dimensions des particules 3 qu'il est envisagé d'utiliser ou inversement, prévoir les dimensions des particules en fonction de la largeur de la tranchée 2.

On définit comme distance linéique L de la tranchée 2 une distance sur laquelle les deux électrodes 11, 12 sont en vis-à-vis et séparés par sensiblement la largeur 1. On définit aussi des hauteurs h11 et h12 respectivement aux deux électrodes référencées 11 et 12, mesurées perpendiculairement à la largeur 1 et à la distance linéique L.

La distance linéique L de la tranchée 2 peut avoir une taille adaptée au nombre de particules 3 que l'on désire voir dans le dispositif et aux dimensions des particules 3. En particulier, la distance linéique L peut mesurer de quelques dizaines de micromètres à quelques mètres si la tranchée 2 est sinueuse, par exemple si les électrodes 11, 12 se présentent sous la forme de peignes interdigités ou si la tranchée 2 est sous la forme d'un serpentin. Inversement, il est possible d'envisager une tranchée 2 de distance linéique L telle qu'une seule particule 3 à la fois peut relier les deux électrodes 11, 12. La forme des particules 3 peut varier. Les particules peuvent être grossièrement sphériques, cylindriques, parallélépipédique ou de forme indéfinie. Il est illustré en figure 2 des formes possibles pour des particules 3, envisageables pour réaliser l'invention.

Les particules 3 utilisées sont de préférence des particules à transition d'état de spin électronique commandée en température à base d'un composé répondant à la formule chimique {1} ci-dessous :

formule chimique {1} : [Fe (G)₃](X)ₙ

où G est un ligand 1,2,4-triazole portant un substituant R sur l'azote en position 4, noté R-Trz ;

Le substituant R peut être choisi parmi l'ensemble composé de l'hydrogène et des composés H₂N-, R₁-, HR₁N-, et R₁R₂N- où R₁ et R₂ sont des radicaux alkyles.

X représente au moins un anion; et n est calculé de telle sorte que l'électroneutralité de la formule soit respectée.

Il est bien entendu que pour un même composé, l'élément (G)₃ est préférentiellement tel que les trois ligands G sont identiques, mais alternativement, l'un des ligands G peut porter un substituant différent des autres ligands G. Encore de façon alternative, les trois ligands peuvent avoir des substituant différents.

Il est à noter qu'en plus du composé vérifiant la formule chimique {1} il peut être intéressant au sens de l'invention de remplacer quelques pourcentages des atomes de fer par un autre métal de transition, par exemple du zinc, du chrome, du ruthénium ou un autre métal de transition de façon à modifier les propriétés photoélectriques du dispositif ou à apporter d'autres propriétés. De même, il peut être intéressant de remplacer quelques pourcentages des ligands G de la particule par des ligands G' qui comportent un substituant R' portant une autre fonctionnalité. La fonctionnalité portée par le substituant R' peut être par exemple une fonctionnalité chromophore ou fluorophore ou une fonctionnalité qui facilite une adhésion ou une répulsion avec des radicaux choisis. Alternativement, les ligands G' peuvent être des ligands anioniques 1,2,4 triazolato, noté Trz, qui ne comportent pas de substituant. Enfin, il est possible de remplacer quelques pourcentages des anions X par des anions Y qui ont une propriété additionnelle, par exemple une propriété chromophore ou une propriété fluorophore ou une propriété de luminescence.

Ces variations de la particule autour du composé vérifiant strictement la formule chimique {1} ne modifient pas de façon fondamentale les propriétés de la particule obtenue. Le remplacement d'un faible pourcentage, par exemple inférieur à 50% ou à 10% ou à 5% ou à 1% ou même à quelques millièmes, d'un ou plusieurs éléments de la formule chimique {1} par un ou plusieurs des éléments de remplacement précités conduit à former des particules ayant le même type de propriété électrique ou photoélectrique que celles présentées plus loin dans cette description. Le pourcentage de composés vérifiant la formule chimique {1} pouvant être remplacé par une variation de ce composé dépend du type de variation envisagée. En particulier, le remplacement de l'atome de fer, présent au centre du composé par un autre métal est avantageusement limité à quelques millièmes ou centièmes des composés formant la particule, par exemple inférieur à 5 pourcents ou inférieur à 5 millièmes des composés. Une variation d'un ou plusieurs substituants R ou des contre-ions peut être du même ordre de grandeur si les substituants ou les contre-ions sont de dimensions importantes relativement aux substituants ou contre-ions d'origine. Par contre si l'on remplace un ligand triazole par un ligand anionique triazolato, il peut être avantageux d'introduire la variation sur sensiblement l'ensemble des composés formant la particule pour un ou deux ligands G par composé.

Ainsi, l'invention couvre aussi les différents dispositifs comportant les particules présentant les variations mentionnées ci-dessus en plus d'un composé vérifiant strictement la formule chimique {1}.

Le tableau de la figure 2 montre plusieurs particules utilisables pour réaliser un dispositif au sens de l'invention, leur formule chimique, leur forme générale, des tailles moyennes obtenues, et des températures T_{1/2up} et T_{1/2down} qui correspondent à des températures provoquant une transition d'état électronique de spin dans les particules. La transition d'état de spin électronique peut présenter un cycle d'hystérésis, c'est-à-dire qu'une transition d'état électronique de spin modifiant le spin dans un sens peut demander une température plus importante ou plus faible que la transition de spin inverse. On peut se référer à l'unique figure de la demande de brevet EP 0842988 pour visualiser un exemple de cycle d'hystérésis pour la transition d'état électronique de spin d'une particule du type de celles utilisables pour former un dispositif selon l'invention.

Les particules de formule [Fe(H-Trz)₂Trz](BF₄) peuvent être de forme cubique ou parallélépipédique, de dimensions comprises environ entre 70 nm par 70 nm par 40 nm et 70 nm par 700 nm par 200 nm et de températures T_{1/2up} et T_{1/2down} respectivement voisines de 380K et 360K. Ces particules illustrent un cas particulier ou un ligand triazole est remplacé par un ligand anionique triazolato, pour une très grande majorité des composés formant les particules.

Les particules de formule [Fe(NH₂-Trz)₃]Br₂ peuvent être de forme sensiblement cubique de côté compris environ entre 70 nm et 150 nm et de températures T_{1/2up} et T_{1/2down} respectivement voisines de 315K et 305K.

Les particules de formule [Fe(NH₂-Trz)₃]Cl₂ peuvent être de forme sensiblement discale ou cylindrique ou parallélépipédique, de dimensions pouvant valoir environ 140 nm par 40 nm ou 100 nm par 150 nm de diamètre pour les cylindres et de températures T_{1/2up} et T_{1/2down} respectivement voisines de 340K et 330K.

Enfin, on y observe la mention de particules de formule [Fe(NH₂-Trz)₃](BF₄)₂, de forme indéfinie, de dimensions proches de 100 nm jusqu'à 150 nm et de températures T_{1/2up} et T_{1/2down} respectivement voisines de 225K et 220K.

Ainsi, les variations autour de la formule chimique {1}, mentionnées plus haut, peuvent être utilisées pour ajouter des fonctionnalités aux particules ou pour faire varier leurs températures de transition d'état électronique de spin, ou faciliter une synthèse de particules de dimension donnée sans pour autant mettre en péril l'existence d'une transition d'état électronique de spin commandée en température ni des propriétés photoélectriques illustrées plus en détail ci dessous.

Le dispositif selon l'invention présente une variation de ses propriétés électriques en fonction d'une intensité lumineuse de la lumière incidente. Il est ainsi possible d'utiliser le dispositif comme un dispositif électrique photosensible.

Les dispositifs selon l'invention peuvent présenter une conductivité intrinsèque, dans l'obscurité, supérieure à 0.1 Sm⁻¹. Cette valeur a été obtenue en rapportant des valeurs mesurées de conductance d'un dispositif selon l'invention à une largeur de la tranchée. Le dispositif selon l'invention est donc un dispositif électrique, même dans l'obscurité, avec une conductivité intrinsèque de l'ordre de celle d'un matériau semiconducteur. On peut alors utiliser le dispositif selon l'invention de la même manière qu'un dispositif électrique standard ou semiconducteur en lui imposant une intensité lumineuse incidente sensiblement constante, par exemple l'obscurité, ou alors comme un dispositif électrique photosensible ou commandé par lumière.

Selon un premier mode de réalisation de l'invention, qui sera décrit plus en détail plus bas, la particule a une fonction de travail sensiblement identique pour chaque électrode et le dispositif selon l'invention est un dispositif photoconducteur. Alors la conductance des particules varie lorsque l'intensité lumineuse imposée varie.

La figure 3 illustre les résultats de tests effectués en vue d'évaluer les performances photoconductrices d'un dispositif selon ce mode de réalisation de l'invention avec en abscisse le temps (en milliers de secondes) et en ordonnée un courant (en ampères) traversant le dispositif lors de l'application d'une tension constante. Ainsi, l'indication du passage d'un courant important implique la présence d'une conductance importante. En partant de l'origine des temps, plusieurs événements sont notés : on observe un plateau 0 de courant, révélant une conductance en l'absence de stimulation lumineuse particulière. Un premier événement A représente la mise en route d'un microscope, permettant de focaliser de la lumière sur le dispositif. Le microscope comporte un éclairage interne et on observe alors une augmentation de courant, proche d'un facteur deux. Puis, on impose au dispositif un cycle B d'alternance d'allumages, événement C, et d'extinctions, événement C', d'une lampe halogène, variant ainsi de façon importante l'intensité lumineuse incidente sur le dispositif. A chaque allumage C de la lampe halogène correspond une augmentation brusque du courant traversant le dispositif. Cela traduit une augmentation importante de la conductance du dispositif et en particulier des particules. Inversement, à chaque extinction C' de la lampe halogène correspond un retour du courant traversant le dispositif au niveau observé lors de l'événement A.

Au point A' on a éteint la lumière interne du microscope, puis en 0' on éteint la lumière de la pièce où ont lieu les tests. Une obscurité quasi-totale est crée lors de l'événement D. Seul un très faible courant circule dans le dispositif.

Ensuite, l'approche d'un écran d'un appareil de télécommunication mobile, du type téléphone portable, ayant une faible intensité lumineuse, produit l'événement E et un courant non nul est mesuré. Ainsi, sans optimisation, un prototype du dispositif selon l'invention détecte la faible luminosité émise par un appareil de télécommunication mobile.

Enfin, une lampe à ultra-violet portable, du type fréquemment trouvé en laboratoire est approchée (événement F). Puis la lampe halogène est rallumée (événement C"). On observe alors respectivement une montée du courant d'un facteur 4 puis encore d'un facteur 2 par rapport à la situation où la lumière de la pièce est allumée (événement 0). Le dispositif photoconducteur, obtenu selon le premier mode de réalisation de l'invention, présente une variation de conductance sur une grande gamme en réponse à un changement de luminosité incidente.

Dans le montage de l'expérience exposée ci-dessus, le faisceau lumineux de la lampe halogène est focalisé par le microscope. Il a été mesuré, au moyen d'une sonde de température, que l'intensité lumineuse présente au point focal du microscope chauffe la sonde jusqu'à lui faire atteindre une température proche de 100°C. La sonde présente des propriétés d'absorption et de transfert thermique données. Ces propriétés ne sont pas identiques et n'ont pas les mêmes valeurs pour les particules utilisées dans l'invention. Il est considéré toutefois que la température des particules est de 100°C sous influence de l'intensité lumineuse focalisée de la lampe halogène.

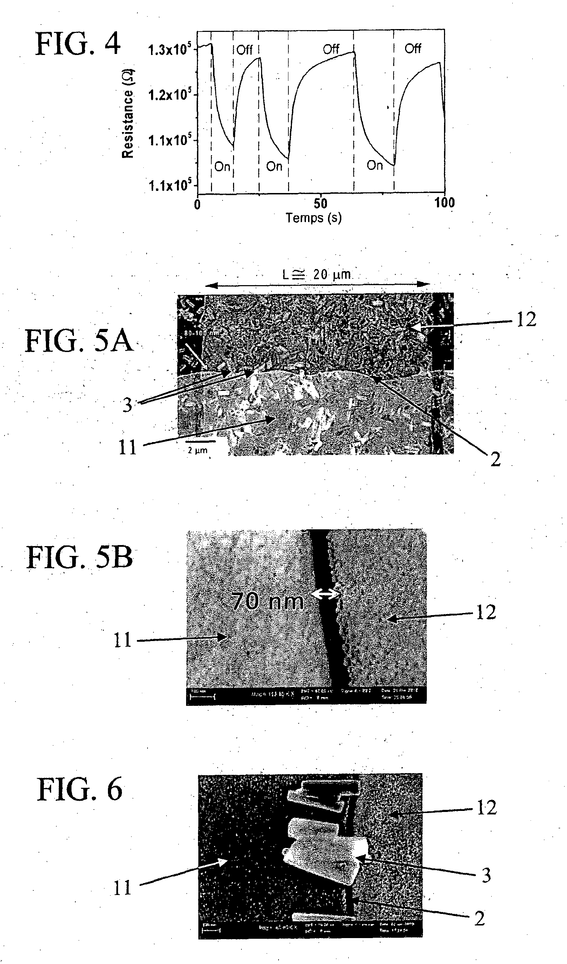

La figure 4 rapporte des valeurs de résistance d'un film d'or en fonction du temps mesurées lorsque l'on éclaire ou l'on éteint une lampe halogène dont la lumière est focalisée en surface du film d'or. On observe un retard à la réponse supérieur à 20 secondes. Lorsque la lumière est allumée, la résistance mesurée diminue pendant quelques dizaines de secondes avant de commencer se stabiliser. De même, lorsque l'on éteint la lumière, il faut attendre quelques dizaines de secondes avant que la résistance ne soit remontée à un niveau proche du niveau initial. On mesure respectivement des retards à la réponse valant au minimum 10, 12 et 15 secondes lors des différents allumages, et 10, 20 et 15 secondes lors des différentes extinctions.

Pour l'or ces retards à la réponse sont représentatifs d'une évolution de la température dans le film. Ainsi, dans l'or (l'un des matériaux ayant une conduction thermique la plus importante), le fait d'allumer ou d'éteindre la lumière ne conduit pas à un changement instantané de la température du film. Des temps de chauffe et de refroidissement influent sur l'évolution de la résistance du film.

Les particules du dispositif selon l'invention ont une conductivité thermique plus faible que l'or. En conséquence, si la variation de conductance observée en figure 3 était principalement liée à une variation de température, on devrait observer un retard à la réponse supérieur et au moins égal à celui de l'or. Comme le temps de réponse est plus rapide pour le dispositif selon l'invention (une à cinq secondes), cela signifie que la variation de conductance présentée en figure 3 est bien illustrative des propriétés photoconductrices du dispositif selon l'invention. Un tel retard à la réponse représente un temps de réponse rapide pour un dispositif photovoltaïque ou photoconducteur.

De façon générale, les particules peuvent être présentes de façon aléatoire à la surface des électrodes et seules certaines particules sont simultanément en contact direct avec les deux électrodes. La figure 5A est une photographie obtenue par microscopie électronique à balayage d'une zone d'un dispositif selon l'invention comportant deux électrodes 11, 12, séparées par une tranchée 2 et dans lequel de nombreuses particules 3 sont présente à la surface des électrodes. La tranchée 2 a une largeur de 70 nm comme l'illustre la figure 5B et a une distance linéique proche de 20 micromètres. On observe, pour cet exemple, approximativement 30 particules actives qui permettent de faire fonctionner le dispositif selon l'invention.

Cependant, dans un mode préféré de l'invention, les particules peuvent être positionnées quasiment uniquement au niveau de la tranchée séparant les deux électrodes. Un détail de ce mode préféré du dispositif est illustré en figure 6. On y observe une photographie obtenue par microscopie électronique à balayage d'une zone d'un dispositif selon l'invention comportant deux électrodes 11, 12, séparées par une tranchée nanométrique 2 et comportant cinq particules 3 qui sont toutes en contact simultané avec les deux électrodes 11, 12, avec une densité de particules au niveau de la tranchée plus importante que dans le mode de réalisation précédemment décrit. Ce mode préféré de l'invention peut être obtenu au moyen d'une variante du procédé selon l'invention qui sera décrite plus bas.

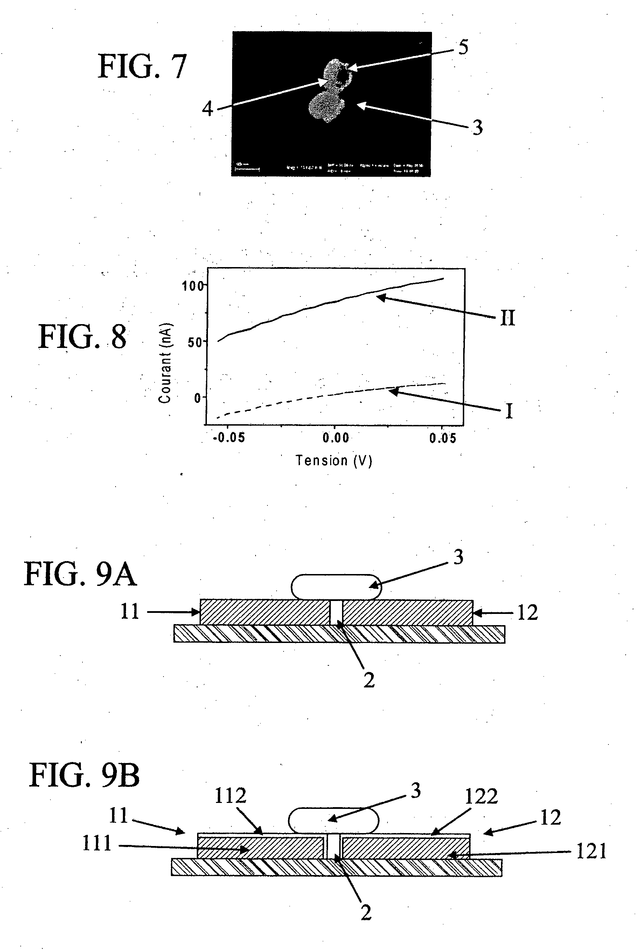

Dans certains modes de réalisation de l'invention une partie des particules utilisées sont partiellement recouvertes de métal, par exemple d'un film de métal. La figure 7 montre une photographie obtenue par microscopie électronique à balayage d'une telle particule 3. On y observe une particule 3 ayant une zone métallisée 4, plus claire, et une zone non métallisée 5, plus foncée. La zone métallisée 4 peut être préférentiellement en contact avec au moins une électrode ou, de façon alternative, la zone non métallisée 5 peut être préférentiellement en contact avec les électrodes.

La zone métallisée peut être en or, en nickel ou en une structure multicouche or-nickel. Cependant, on peut remplacer l'or par un autre métal, en particulier un autre métal du même groupe : argent, cuivre, etc. ou d'autres métaux ou leurs alliages. De même, on peut remplacer le nickel par un autre métal, par exemple par un autre métal ou alliage de métaux ayant des propriétés magnétiques telles que du fer ou par un autre métal tel que du ruthénium. Alternativement, le métal peut être remplacé par un matériau ayant des propriétés optiques particulières ou semiconductrices ou isolantes telles que du silicium ou un oxyde.

Dans un premier mode particulier de réalisation de l'invention, illustré par la figure 1, la particule active 3, en contact direct simultané avec les deux électrodes 11, 12, a un contact électrique sensiblement identique avec les deux électrodes. Le dispositif photoélectrique selon l'invention a alors une fonction de travail sensiblement identique pour chaque électrode et le dispositif se comporte comme un photoconducteur, comme rapporté en figure 3. Ainsi, un dispositif dont seule la conductance varie avec la luminosité incidente sur le dispositif, peut être obtenu par la mise en oeuvre du premier mode particulier de réalisation de l'invention.

Pour permettre ce contact électrique sensiblement identique aux deux électrodes 11, 12 il est préférable qu'au moins les surfaces des deux électrodes 11, 12 soient dans un même métal.

Dans un second mode particulier de réalisation de l'invention, on introduit de manière délibérée une dissymétrie entre le contact électrique de la particule avec l'une des deux électrodes et le contact électrique de la particule avec l'autre des deux électrodes. Il est alors formé une dissymétrie entre les fonctions de travail des deux électrodes et un tel dispositif selon le second mode particulier de réalisation de l'invention possède des propriétés photovoltaïques.

Ainsi, lorsque le dispositif est éclairé par une source de lumière donnée, il produit en réaction une tension à ses bornes, même en l'absence d'une arrivée de courant extérieure au dispositif. La tension dépend de l'intensité lumineuse du faisceau lumineux incident sur le dispositif depuis la source de lumière.

Le dispositif peut présenter cette propriété selon deux dispositions. Une première disposition consiste à prévoir un dispositif dans lequel une des particules a un contact électrique avec une électrode telle que sa résistance d'accès est plus faible d'un facteur 10 à 1000 par rapport à l'autre électrode. Il sera présenté plus bas une étape avantageuse de procédé appelée « soudure en tension » qui a pour but de réduire la résistance d'accès plus faible entre la particule et les électrodes. Pour certains dispositifs, l'étape de soudure en tension ne réduit la résistance d'accès des particules actives que pour une seule des deux électrodes. Ainsi, pour ces dispositifs, l'étape de soudure en tension a fonctionnée de manière non-symétrique. Les particule(s) ont alors une « soudure dissymétrique » avec les deux électrodes. Le dispositif est alors un dispositif photovoltaïque.

La dissymétrie est ainsi obtenue sans qu'il y ait de dissymétrie structurelle macroscopique. Cette soudure dissymétrique qui se traduit par une résistance d'accès plus faible sur une électrode que sur l'autre électrode s'interprète par de possibles différences structurelles atomiques au niveau des contacts entre la particule et les électrodes. L'observation d'un caractère photovoltaïque sur un dispositif selon l'invention qui ne présente pas de dissymétrie structurelle macroscopique est révélatrice d'une dissymétrie de fonction de travail obtenue selon la manière exposée ci-dessus.

De tels dispositifs photovoltaïques sont obtenus de manière aléatoire, avec à peu près dix à trente pourcents de chance, lors de la fabrication de dispositifs photoconducteurs selon l'invention. Il est donc préférable de tester chaque dispositif pour savoir lesquels sont des dispositifs ayant des propriétés photovoltaïques et lesquels sont des dispositifs uniquement photoconducteurs. Cependant, ces dispositifs photovoltaïques sont obtenus sans complexifier la structure ou le procédé de fabrication par rapport aux dispositifs photoconducteurs présentés plus haut.

Un prototype d'un dispositif selon ce deuxième mode de réalisation particulier de l'invention a été testé et les résultats de fonctionnement sont présentés en lien avec la figure 8, représente des courbes I de V (courant en fonction d'une tension mesurée aux bornes du dispositif). Une première mesure a été effectuée avec une absence d'éclairage dans la pièce (courbe I) et il est observé une courbe I de V croisant l'origine zéro ampère, zéro volt. Une deuxième mesure de courant, obtenue cette fois sous éclairage du dispositif par une lumière issue de la lampe halogène et focalisée sur le dispositif est illustré en courbe II. Cette courbe ne passe pas par l'origine zéro ampère, zéro volt et montre donc une génération d'un courant qui peut atteindre approximativement 100 nA pour certaines valeurs de tension. La génération de courant par effet photovoltaïque est en particulier illustrée par la génération d'un courant proche de 75 nanoampères pour une tension appliquée de zéro volt.

Comme les particules utilisées pour cette expérience ont une épaisseur proche de 200 nm, que la tranchée a une largeur d'environ 100 nm et s'étend sur une distance linéique proche de 5 microns, on peut estimer que le courant mesuré correspond à une densité de courant proche de 8.10⁴ A.m⁻². Sachant de plus qu'il a été utilisé une technique de dépôt des particules, précisée plus bas, qui conduit à avoir un dépôt aléatoire des particules sur la surface des électrodes, les particules actives sont insuffisantes en nombre et en densité. La dissymétrie des contacts électriques est obtenue dans les particules par une soudure dissymétrique qui est aussi un processus aléatoire. Ainsi, dans une réalisation avantageuse, le dispositif peut être optimisé pour obtenir une photogénération plus importante.

Une deuxième disposition pour que le dispositif selon l'invention ait des propriétés photovoltaïques consiste à prévoir un dispositif dans lequel le contact des électrodes avec les particules est réalisé en un métal différent d'une électrode à l'autre. Par exemple, les surfaces des deux électrodes 11, 12 peuvent être dans des métaux différents. Une dissymétrie « de construction » des fonctions de travail peut alors être imposée.

Chaque électrode peut être formée d'un unique métal tel qu'illustré dans la figure 9A. Ce métal peut être différent d'une électrode à l'autre ou non selon le mode particulier de réalisation de l'invention employé.

De manière alternative, ainsi qu'illustré en figure 9B, chacune des deux électrodes a un coeur d'électrode 111, 121 en un métal donné. Le métal du coeur d'électrode 111, 121 peut être identique ou différent pour les deux électrodes 11, 12. Le métal du coeur d'électrode 111, 121 peut avoir été choisi pour fournir une autre fonctionnalité au dispositif. De plus, chacune des électrodes 11, 12 est recouverte, au moins là où les particules 3 sont en contact avec les électrodes 11, 12, par une couche métallique de surface 112, 122. Les couches métalliques de surface 112, 122 des deux électrodes peuvent être en un même métal. Ou, de façon alternative, l'une des deux couches métalliques de surface 112, 122 est en un premier métal et l'autre des deux couches métalliques de surface 112, 122 est en un deuxième métal, différent du premier métal selon le mode particulier de réalisation de l'invention employé.

L'une et/ou l'autre des deux couches métalliques de surface 112, 122 peuvent être dans le même métal que le coeur d'électrode 111, 121 sur lesquels elles se trouvent respectivement.

Les couches métalliques de surface 112, 122 des électrodes peuvent être en tout métal, tels par exemple de l'argent, de l'or, du cuivre, du nickel, de l'aluminium, etc. Les tests effectués et illustrés en lien avec les figures 3 et 8 ont été réalisés avec des électrodes dont la surface est en or, ou en une structure multicouche d'or et de nickel. On peut aussi obtenir un dispositif photovoltaïque selon le deuxième mode particulier de réalisation de l'invention avec deux électrodes dont l'une a une couche métallique de surface 112 en or et l'autre a une couche métallique de surface 122 en aluminium. Selon la présente invention, un mode avantageux consiste, indépendamment de la nature de la surface des électrodes, à prévoir les coeurs des électrodes en un matériau magnétique ou magnétisable. Ce peut en particulier être du nickel ou un autre métal ou alliage de métal magnétique ou magnétisable.

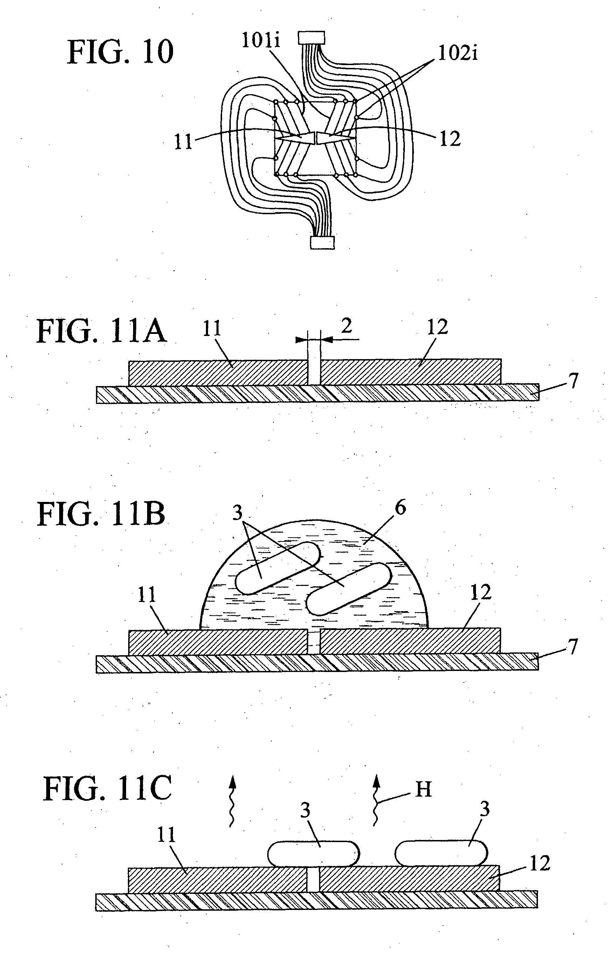

La figure 10 est une vue schématique d'un banc de test utilisé pour mesurer les performances des dispositifs photoélectriques selon les différents modes de réalisation de l'invention. On y observe un prototype de dispositif selon l'invention 1, comportant deux électrodes 11, 12 reliée par des pattes 101i à des contacts 102i présents sur le banc de test. On observe de plus des fils reliant les contacts à des amenées extérieures de courant.

Le dispositif selon l'invention peut être réalisé avec une unique particule active ou avec plusieurs particules actives par dispositif.

De même, les particules présentées dans cette description sont principalement des particules de taille nanométrique, par exemple comprise entre 30 nm et 700 nm, mais le dispositif selon l'invention peut être réalisé avec des particules de taille plus importante. En conséquence, l'invention ne se limite pas à des particules de taille nanométrique.

L'invention vise aussi un procédé pour réaliser les dispositifs selon l'invention.

Un descriptif général du procédé de fabrication des dispositifs selon l'invention est illustré en lien avec les figures 11A à 11C.

En premier lieu, il est fourni un substrat 7 comportant en surface deux électrodes 11, 12 séparées par une tranchée 2 (figure 11A).

Des particules 3 sont ensuite déposées sur le dispositif au niveau de la tranchée 2 (figure 11B). Les particules 3 sont avantageusement en suspension dans une solution liquide. La solution liquide comportant les particules 3 est donc déposée, par exemple sous la forme d'une application localisée d'une goutte 6 sur le dispositif, au niveau de la tranchée 2.

La solution liquide est ensuite évaporée (figure 11C), par exemple au moyen d'un traitement thermique H, ce qui conduit à mettre les particules 3 en contact direct avec la surface du dispositif. En particulier, au moins une particule 3 est déposée en contact direct simultané avec les deux électrodes 11, 12.

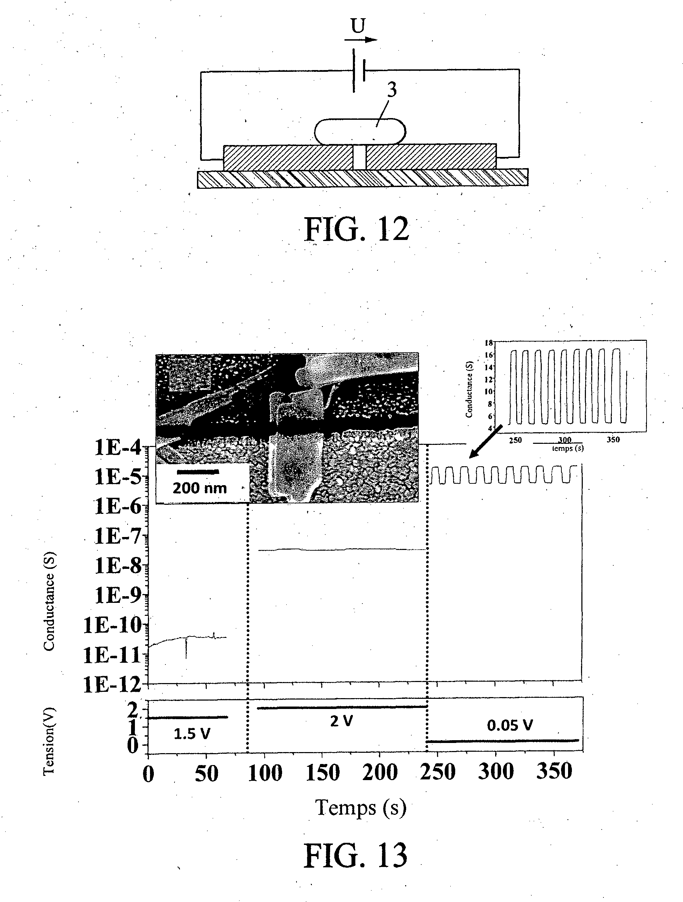

Les particules 3 sont retenues à la surface des électrodes, après évaporation de la solution liquide, par physisorption ou chimisorption. Par exemple, des groupements -NH₂ situés en périphérie des particules 3 peuvent interagir avec des atomes présents en surfaces des électrodes. Par ailleurs, il peut être ajouté des groupements fonctionnels en surface des électrodes ou sur les particules de façon à faciliter une liaison chimique. Ces groupements peuvent être par exemple des groupements ioniques ou atomes d'hydrogène, ou des radicaux thiols, thioaryles, benzonitriles... De façon préférentielle, suite à l'évaporation de la solution liquide, on applique une étape de soudure en tension sous la forme de l'application d'une tension U entre les deux électrodes (figure 12). La tension U est adaptée aux dimensions des électrodes et au nombre de particules 3 attendues entre les deux électrodes 11, 12. La tension U est calibrée de façon à réduire les résistances d'accès entre les électrodes 11, 12 et les particules 3, tout en restant suffisamment faible pour ne pas détruire les particules 3 ou la tranchée séparant les électrodes. La tension U produit une modification de l'interface entre les particules et les électrodes. Cette modification change le contact électrique entre les particules et les électrodes et en diminue la résistance d'accès. Elle permet de réduire, au moins pour l'une des deux électrodes, la résistance d'accès d'un facteur 10 à 1000 ou plus.

Dans l'exemple de réalisation d'un dispositif selon l'invention comportant une tranchée de largeur sensiblement égale à 70 nm et de distance linéique proche de 20 micromètres et une trentaine de particules actives, il peut être appliqué une tension de l'ordre d'un ou deux volts pendant quelques secondes. Selon les particules utilisées, le phénomène de soudure en tension peut avoir lieu dès 0,5 V et peut ne pas avoir lieu jusqu'à environ 5 V. Ainsi, l'homme de l'art appliquera de préférence une tension environ comprise entre 0,5 V et 5V pour obtenir une soudure en tension.

S'il est attendu une densité plus importante de particules actives, ou si la tranchée est plus large ou plus longue, on pourra utiliser des valeurs qui peuvent être hors de la gamme de tensions précédente donnée à titre d'exemple.

La figure 13 illustre le phénomène d'amélioration de la conductance obtenue par l'application de la soudure en tension selon ce mode préféré de réalisation du procédé selon l'invention. Il y est représenté de façon principale des résultats de mesure de conductance (en siemens) en fonction du temps (en secondes) pour un dispositif selon l'invention en partant d'un temps t₀. Pour ce test, comme illustré dans l'encart en haut à gauche, les particules sont de dimensions nanométriques et les électrodes sont en or. On mesure en premier lieu, après évaporation de la solution liquide contenant les particules, une conductance inférieure à 4.10⁻¹¹ siemens. Une tension de mesure proche de 1,5 V est utilisée. Au temps t = 100 secondes une tension sensiblement égale à 2 V est imposée aux bornes du dispositif. Cette tension, qui met en application l'étape de soudure en tension du procédé de l'invention, sert aussi de tension de mesure. La conductance augmente et atteint une valeur proche de 4.10⁻⁸ siemens, soit une valeur 1000 fois plus importante qu'avant la soudure en tension.

Ensuite, à un temps proche de 250 secondes on réduit la tension de mesure à environ 0,05 V et on applique des cycles d'allumage et d'extinction d'une lampe halogène dont la lumière est focalisée sur le dispositif (dits cycles ON/OFF), à l'instar du test rapporté en lien avec la figure 3. Les variations de conductance mesurées lors des cycles ON/OFF sont rapportés de façon agrandie dans l'encart en haut à droite de la figure 13.

Les mesures rapportées dans la figure 13 illustrent bien que l'application d'une tension de l'ordre de 2 V aux bornes de ce prototype du dispositif selon l'invention produit un effet permanent de soudure en tension qui réduit la résistance d'accès entre les électrodes et les particules.

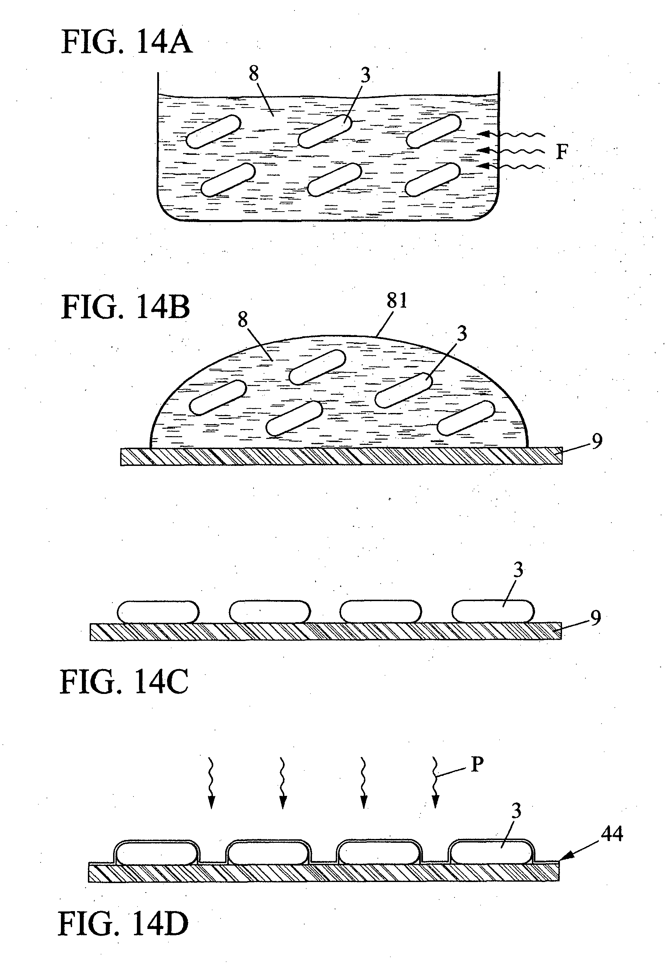

Il va être présenté dans la suite un exemple de procédé de dépôt de métal sur des particules selon l'invention (figures 14A à 14E).

Les particules 3 sont tout d'abord mises en suspension dans une solution 8 (figure 14A). La solution peut être à base d'éthanol ou de tout autre solvant qui n'entraîne pas la solubilisation des particules et qui possède un bon pouvoir d'évaporation, tel que du diéthyl-éther, de l'eau, etc.

La solution 8 est soumise à des ultrasons F pendant approximativement cinq minutes de façon à assurer une bonne séparation des particules les unes des autres et éviter une agrégation des particules entre elles.

Cette solution 8 contenant les particules est ensuite déposée sur un support solide 9, par exemple sous la forme d'une goutte 81 déposée sur une surface d'or, de nickel ou en surface d'un substrat de silicium, etc. (figure 14B).

Il est ensuite procédé à l'évaporation de la solution 8, laissant les particules 3 déposées en contact direct avec le support solide 9 (figure 14C).

Puis on procède au dépôt P d'une couche et/ou multicouche métallique 144 par une ou plusieurs techniques d'évaporation sous vide (figure D). Il est possible d'utiliser une technique d'évaporation Joule, un dépôt par canon à électrons, un dépôt physique en phase vapeur, un dépôt chimique en phase vapeur, etc. Un côté des particules 3 est en contact avec le support solide 9 et ne peut donc être recouvert de métal. En conséquence, les particules 3 n'ont une zone métallisée 4 que sur un seul côté.

Le ou les métaux composant la couche métallique 144 sont de préférence ceux cités plus haut en liaison avec la figure 7.

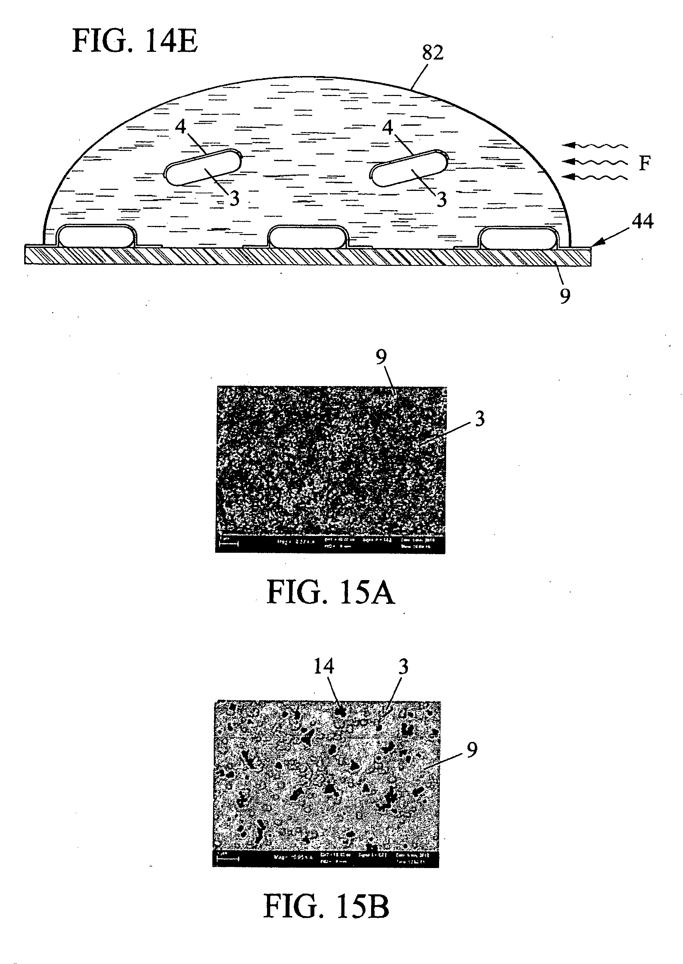

On met à nouveau le support solide 9 comportant les particules 3 en contact avec une solution 82, ne comportant pas de particules, et on soumet l'ensemble à des ultrasons F de façon à arracher une partie des particules 3 du support solide 9 (figure 14E). La mise en contact du support solide 9 comportant les particules avec la solution 82 peut se faire en déposant de la solution sur le support solide, par exemple sous la forme de gouttes, ou en immergeant le support solide 9 dans un conteneur comportant un certain volume de solution 82 ou toute autre solution appropriée. On obtient alors en suspension dans la solution 82 des particules 3 recouvertes partiellement d'un film de métal formant une zone métallisée 4.

Les figures 15A et 15B sont deux photographies obtenues par microscopie électronique à balayage représentant des particules 3 présentes sur un support physique 9. La photographie de la figure 15A a été faite avant l'étape de métallisation. En figure 15B, les particules 3 et le support physique 9 ont été métallisés et des ultrasons ont été appliqués. On note la présence de taches sombres représentatives de zones d'arrachement 14 d'où des particules partiellement métallisées ont été arrachées et remises en suspension suite à l'action des ultrasons.

Les particules 3 comportant une zone métallisée 4 peuvent être utilisées directement dans un dispositif selon l'invention pour les propriétés conductrices et/ou optiques du film de métal composant la zone métallisée.

En particulier, en ajoutant des groupements fonctionnels, par traitement ou par greffage, sur les zones non métallisée 5 des particules, sur les zones métallisées 4 des particules 3 et/ou sur les électrodes 11, 12, il est possible de forcer soit une majorité des particules 3 à avoir leur zone métallisée 4 en contact avec les électrodes 11, 12, formant un contact métal/métal, soit une majorité des particules 3 à avoir leur zone non-métallisée 5 en contact avec les électrodes 11, 12, formant un contact métal/organique.

Par exemple, on peut fonctionnaliser les électrodes de façon à ce qu'elles réagissent chimiquement de façon préférentielle avec les zones métallisées ou avec les zones non métallisées, ou avec un groupement fonctionnel présent en surface de ces dites zones. Ce peut être fait en appliquant un traitement plasma oxygène, ou un plasma hydrogène, ou en greffant des groupements fonctionnels en surface des électrodes. Par exemple, pour former un contact métal/métal, il est avantageux de déposer des groupements organiques, par exemple, thioaryle, dithioaryle, benzonitrile reconnus pour leur affinité avec certaines surfaces métalliques (Or, Nickel,...) à la surface des électrodes. Ainsi, les électrodes 11, 12 forment un contact préférentiel avec les zones métallisées 4 des particules.

Inversement, ou en complément, il peut être avantageux de fonctionnaliser les particules.

Dans un premier cas on procède à un premier traitement de fonctionnalisation des particules 3 en solution avant l'étape de métallisation. Alors, après métallisation, la couche de métal recouvre les groupements fonctionnels pour la zone métallisée 4. Les groupements fonctionnels, favorisant ou défavorisant une liaison avec les électrodes, ne sont présents plus que sur les zones non métallisées 5. Par exemple, pour former un contact organique/métal, on peut envisager de fixer des groupements fonctionnels aux substituants des ligands G des particules, côté non métallisée. Par exemple, pour le cas des particules à base de 4-amino-1,2,4-triazole, le substituant amine peut être couplé à une fonction aldéhyde afin de greffer des groupements, par exemple, thioaryle, benzonitrile reconnus pour leur affinité avec certaines surface métalliques (Or, Nickel,...).

Alternativement, ou en complément, il est possible dans un deuxième cas de fonctionnaliser les zones métallisées. Alors, de préférence, on procède à un second traitement de fonctionnalisation des particules après l'étape de métallisation et avant d'arracher les particules du support solide. Ainsi, le traitement de fonctionnalisation n'est appliqué que sur la zone métallisée. Après arrachement des particules 3, les groupements fonctionnels ajoutés lors du second traitement de fonctionnalisation sont présents uniquement sur la zone métallisée 4 et non sur la zone non-métallisée 5.

Il peut être avantageux de fonctionnaliser les zones non métallisées avec un premier groupement fonctionnel, les zones métallisées avec un second groupement fonctionnel et les électrodes avec un troisième groupement fonctionnel.

Le choix des différents groupes fonctionnels, de la nature des particules et de la nature des métaux utilisés, peut avantageusement permettre de prédéterminer la façon dont les zones métallisées seront positionnées relativement aux électrodes pour une majorité des particules. Ainsi, il peut être déterminé si la zone métallisé aura principalement un impact sur les propriétés optiques ou chimiques du dispositif influant sur l'interaction du dispositif avec des stimuli extérieurs ou sur des propriétés électriques influant sur le contact électrique et la résistance du dispositif.

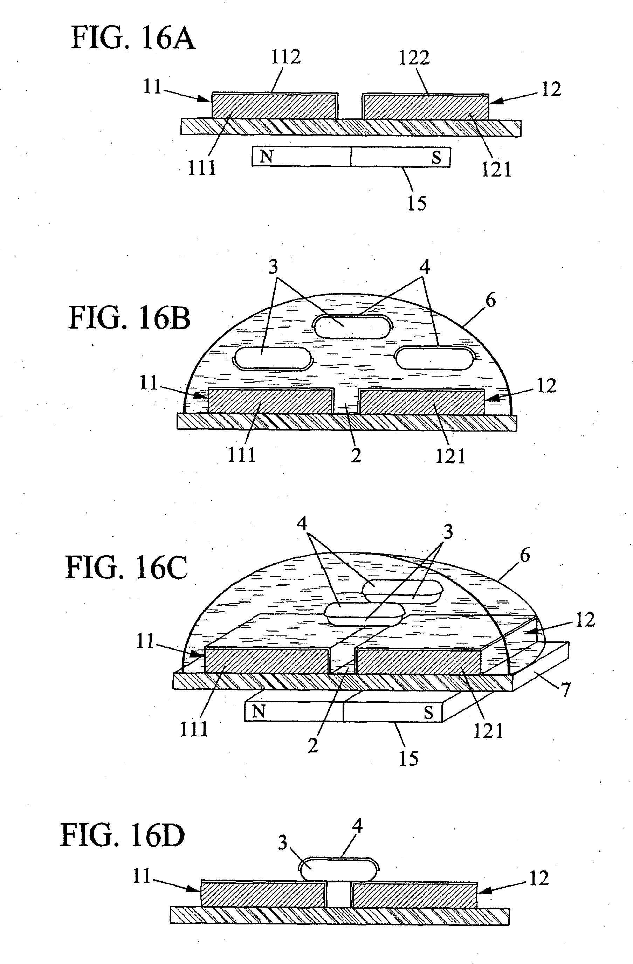

Cependant, si la zone métallisée 4 présente sur les particules 3 comporte au moins une couche métallique magnétique ou magnétisable, il sera possible d'employer dans le procédé de réalisation de dispositifs selon l'invention une étape avantageuse d'organisation des particules décrit ci-dessous en lien avec les figures 16A à 16D. Pour cette étape avantageuse, les électrodes 11, 12 comportent toutes les deux un coeur d'électrode 111, 121 en matériau magnétique ou magnétisable. Les coeurs d'électrodes peuvent être par exemple en nickel ou en fer ou en un autre matériau magnétisable. L'une et/ou l'autre des deux électrodes 11, 12 peut être recouverte d'une couche métallique de surface 112, 122 en un métal différent du coeur d'électrode 111, 121 selon le type de dispositif que l'on désire réaliser.

Selon le procédé avantageux de l'invention, préalablement au dépôt de la goutte 6 contenant la ou les particules 3, on magnétise les électrodes 11, 12.

Pour ce faire il est préférable de soumettre les électrodes 11, 12 à un champ magnétique (figure 16A). Par exemple, il est possible d'approcher les électrodes d'un aimant permanent 15 de faible intensité.

Ensuite, on dépose la goutte 6 de solution liquide comportant des particules 3 en suspension (figure 16B) sur le dispositif et en particulier au dessus des électrodes 11, 12. Les particules 3 sont partiellement recouvertes d'une zone métallisée 4 dont au moins une couche est en matériau magnétique ou magnétisable tel que du nickel. Enfin, dans un troisième temps, on procède à une étape d'organisation automatique des particules 3 au niveau de la tranchée 2 séparant les électrodes.

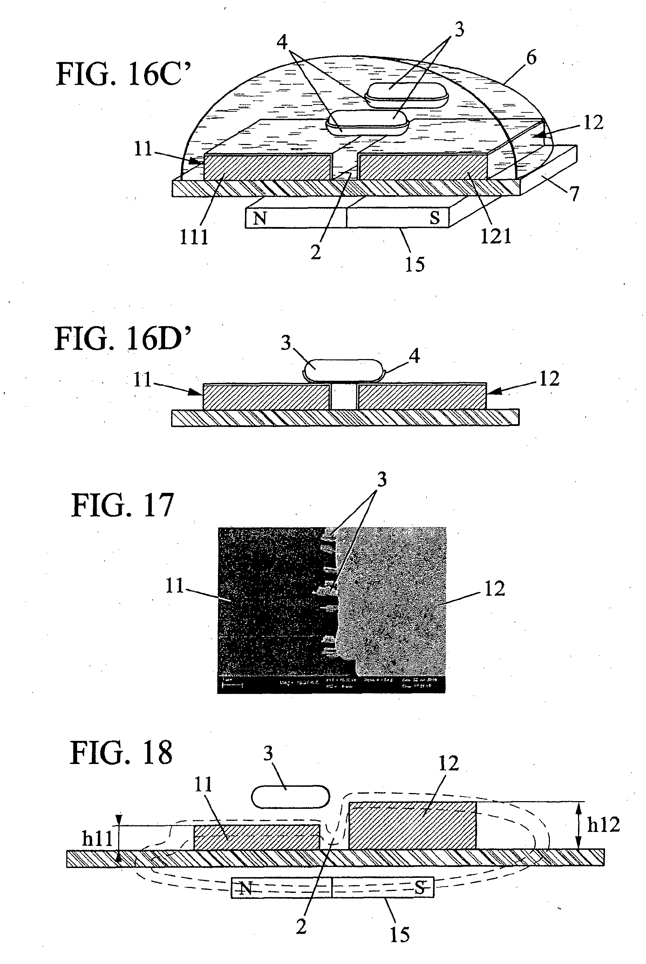

Pour cela, une méthode préférée est de soumettre les zones métallisées 4 des particules 3 en suspension à un champ magnétique imposé (figure 16C). Le champ magnétique imposé peut être obtenu en présentant un aimant permanent 15 sous le substrat 7 qui supporte les électrodes 11, 12 et la goutte 6 de solution liquide. Alors tel qu'illustré sur la vue en trois dimensions de la figure 15C, les particules 3, pilotées par l'aimant permanent 15, les électrodes magnétisées et la zone métallisée 4 magnétisable ou magnétique qui les recouvre, viennent se positionner préférentiellement au niveau de la tranchée 2. Dans l'exemple de la figure 16C, les particules 3 sont positionnées avantageusement avec leur zone métallisée positionnée de façon opposée aux électrodes. Il est aussi possible, comme précisé plus haut d'introduire des groupements fonctionnels sur les particules ou sur les électrodes de façon à ce que les zones métallisées soient attirées préférentiellement par les électrodes (figure 16C').

En effet, l'aimant 15 créé un champ magnétique imposé au niveau de la surface des électrodes 11, 12 et du substrat 7. Les coeurs d'électrodes 111, 121, magnétisés ou magnétisables, modifient le champ magnétique local en l'augmentant par rapport au champ magnétique imposé. Par contre, au niveau de la tranchée 2, le champ magnétique est proche de la valeur donnée seule par le champ magnétique imposé. En conséquence, l'action cumulée du champ magnétique imposé et des coeurs d'électrode 111, 121 conduit à former un gradient de champ magnétique entre les électrodes, au niveau de la tranchée 2. Le gradient de champ magnétique attire les zones métallisées 4 des particules 3.

Ensuite, on procède à une évaporation de la solution liquide (figure 16D). Une très grande partie des particules présentes en solution initialement se déposent alors en contact direct simultané avec les deux électrodes 11, 12. Dans l'exemple de la figure 16D, les particules 3 sont positionnées avantageusement avec leur zone non métallisée en contact avec les électrodes. Il est aussi possible, comme précisé plus haut d'introduire des groupements fonctionnels sur les particules ou sur les électrodes de façon à ce que les électrodes soient préférentiellement en contact avec les zones métallisées des particules (figure 16D').

Dans cet exemple la magnétisation des coeurs d'électrodes 111, 121 a été faite avant le dépôt de la goutte de solution comportant les particules en suspension. Alternativement, il est possible d'effectuer la magnétisation des coeurs d'électrodes 111, 121 après avoir déposé la goutte de solution. Dans ce cas, les étapes de magnétisation et d'organisation des particules sont simultanées.

La figure 17 est une image obtenue par microscopie électronique à balayage d'un dispositif obtenu par application du procédé avantageux illustré au moyen des figures 16A à 16D. On y observe deux électrodes 11, 12 et des particules 3 alignées à l'interface entre les deux électrodes. Cette interface entre les deux électrodes est révélatrice de la position de la tranchée qui sépare les deux électrodes. On observe bien de plus que les particules 3 sont en contact direct avec chacune des deux électrodes 11, 12.

Lors de l'application de l'étape d'organisation automatique des particules il peut être avantageux, comme illustré en figure 18, que les électrodes aient des hauteurs h différentes. Une première 11 des deux électrodes peut être plus basse que la deuxième 12 des deux électrodes. Ainsi après magnétisation des électrodes 11, 12 et lors de l'application du champ magnétique imposé, le gradient de champ magnétique local au niveau de la tranché incite les particules 3 à se positionner en contact avec la deuxième des deux électrodes mais avec une plus grande proportion située au dessus de la première électrode 11 et en contact avec celle-ci.

Les domaines d'applications des dispositifs selon les différents modes de réalisation de l'invention sont multiples, notamment dans le domaine du photovoltaïque, dans le domaine en émergence de l'électronique moléculaire, et plus largement dans le domaine des matériaux 'dits intelligents' à savoir répondant à un stimulus externe (température, pression, lumière). Par exemple, on peut choisir les particules du dispositif selon l'invention de façon à ce qu'elles aient une température de transition d'état électronique de spin choisie pour correspondre à une température critique. Cette température critique peut être révélatrice d'une température de fatigue du dispositif ou une température à partir de laquelle on a besoin de plus de puissance photovoltaïque. Un tel dispositif photosensible peut permettre de faire un dispositif photovoltaïque qui, sous l'effet de l'échauffement, changerait d'état électronique de spin, et donc par exemple de couleur, donc de propriétés d'absorption. Alors le dispositif est 'autorégulé', à savoir qu'il s'autolimite pour éviter des par exemple des échauffements excessifs.

Le dispositif selon l'invention a été décrit principalement avec des particules à base d'un composé vérifiant la formule chimique {1}. On s'attend à obtenir des résultats comparables pour un dispositif comprenant une particule qui ne vérifie pas la formule chimique {1} mais qui présente une transition d'état électronique de spin commandée en température.

## Revendications

1. Dispositif électrique comportant deux électrodes séparées l'une de l'autre **caractérisé en ce que** au moins une particule à transition d'état de spin électronique commandé en température est en contact direct avec chacune des deux électrodes, la particule étant de type ionique et comportant un métal de transition qui porte une charge cationique.

2. Dispositif selon la revendication 1, dans lequel la particule est à base d'un composé répondant à la formule :
[Fe(G)₃](X)ₙ
Où G est un ligand 1,2,4-triazole portant un substituant R sur l'azote en position 4, noté R-Trz ;
X représente au moins un anion;
et n est calculé de telle sorte que l'électroneutralité de la formule soit respectée.

3. Dispositif selon la revendication 2, dans lequel le substituant R est choisi parmi l'ensemble composé de l'hydrogène et des composés H₂N-, R₁-, HR₁N-, et R₁R₂N- où R₁ et R₂ sont des radicaux alkyles.

4. Dispositif selon l'une des revendications 1 à 3, dans lequel la particule est une particule nanométrique dont au moins une dimension est comprise entre 30 nm et 700 nm.

5. Dispositif selon la revendication 4, dans lequel la particule est recouverte de façon dissymétrique par une couche de métal.

6. Dispositif selon l'une des revendications 1 à 5, apte à fonctionner comme dispositif photoconducteur, dans lequel les deux électrodes sont recouvertes par un même métal.

7. Dispositif selon l'une des revendications 1 à 6, apte à fonctionner comme dispositif photovoltaïque, dans lequel une des deux électrodes est recouverte par un premier métal et l'autre des deux électrodes est recouverte par un deuxième métal, différent du premier métal.

8. Dispositif selon l'une des revendications 5 à 7, dans lequel le métal est choisi parmi l'un des éléments de la liste consistant en l'or, le nickel et une structure multicouche or-nickel.

9. Dispositif selon l'une des revendications 1 à 8, dans lequel les électrodes sont séparées par une tranchée imposant une distance inférieure ou sensiblement égale à 100 nanomètres entre les deux électrodes.

10. Dispositif selon l'une des revendications 1 à 9, dans lequel les électrodes sont séparées par une tranchée et sont en vis-à-vis sur une distance linéique comprise entre quelques micromètres et quelques mètres.

11. Dispositif selon l'une des revendications 1 à 10, dans lequel les deux électrodes ont des hauteurs, définies perpendiculairement à un plan principal commun aux deux électrodes, différentes l'une de l'autre.

12. Dispositif selon l'une des revendications 1 à 11, apte à fonctionner comme un dispositif photoélectrique et apte à changer de propriétés photoélectriques à partir d'une température prédéterminée, dans lequel les particules à transition d'état électronique de spin sont choisies parmi les particules à transition d'état de spin électronique commandée en température dont la transition d'état électronique de spin a lieu autour de la température spécifiée.

13. Procédé de fabrication d'un dispositif selon l'une des revendications précédentes comportant les étapes successives suivantes :
a) fourniture de deux électrodes métalliques sur un substrat séparées l'une de l'autre par une tranchée,
b) dépôt d'au moins une particule à transition d'état de spin électronique commandée en température de façon à ce qu'elle soit en contact direct simultané avec les deux électrodes, sous la forme d'une application localisée d'une solution liquide comportant la particule en solution ionique suivie d'une évaporation de la solution liquide qui laisse la particule sur le dispositif, la particule étant de type ionique comportant un métal de transition qui porte une charge cationique, l'électroneutralité de la solution liquide étant assurée par un contre-ion anionique.

14. Procédé selon la revendication 13 comportant, après l'étape b), l'application d'une tension entre les deux électrodes, suffisamment élevée pour réduire les résistances d'accès entre les électrodes et la particule, mais suffisamment faible pour ne pas détruire la particule ou la tranchée séparant les électrodes.

15. Procédé selon la revendication 14 dans lequel la tension appliquée est comprise entre 0,5 volts et 5 volts.

16. Procédé selon l'une des revendications 13 à 15 dans lequel les électrodes comportent au moins un métal magnétisable et dans lequel on prévoit préalablement à l'étape b) :
- une étape dans laquelle on recouvre partiellement la particule à déposer à l'étape b) d'une couche de métal ayant des propriétés magnétiques,
- et une étape de magnétisation des électrodes au moyen d'une application d'un champ magnétique au niveau des deux électrodes,
et dans lequel l'étape b) comporte, entre le dépôt de la solution liquide et son évaporation, une étape d'organisation des particules au niveau de la tranchée séparant les électrodes au moyen d'une application d'un champ magnétique au niveau des deux électrodes.

## Patentansprüche

1. Elektrische Vorrichtung umfassend zwei Elektroden, welche voneinander getrennt sind, **dadurch gekennzeichnet, dass** mindestens ein Partikel mit einem Zustandsübergang des Elektronenspins, welcher durch die Temperatur gesteuert wird, im direkten Kontakt mit jeder der beiden Elektroden ist, wobei das Partikel vom ionischen Typ ist und ein Übergangsmetall umfasst, das eine kationische Ladung trägt.

2. Vorrichtung nach Anspruch 1, wobei das Partikel auf einer Verbindung basiert mit der Formel:
[Fe(G)₃](X)ₙ,
worin G ein 1,2,4-Triazol-Ligand ist, welcher einen R-Substituenten an dem Stickstoff-Atom an der 4-Position trägt, bezeichnet als R-Trz;
X mindestens ein Anion darstellt;
und n so berechnet ist, dass die Elektroneutralität der Formel eingehalten wird.

3. Vorrichtung nach Anspruch 2, wobei der Substituent R aus der Gruppe bestehend aus Wasserstoff und den Verbindungen H₂N-, R₁-, HR₁N- und R₁R₂N-ausgewählt ist, worin R₁ und R₂ Alkylreste sind.

4. Vorrichtung nach einem der Ansprüche 1 bis 3, wobei das Partikel ein Nanopartikel ist, das mindestens eine Abmessung zwischen 30 nm und 700 nm aufweist.

5. Vorrichtung nach Anspruch 4, wobei das Partikel asymmetrisch durch eine Metallschicht abgedeckt wird.

6. Vorrichtung nach einem der Ansprüche 1 bis 5, die geeignet ist, um als photoleitende Vorrichtung betrieben zu werden, wobei die beiden Elektroden mit dem gleichen Metall bedeckt sind.

7. Vorrichtung nach einem der Ansprüche 1 bis 6, die geeignet ist, um als photovoltaische Vorrichtung betrieben zu werden, wobei eine der beiden Elektroden mit einem ersten Metall und die andere der beiden Elektroden mit einem zweiten Metall bedeckt ist, welches sich von dem ersten Metall unterscheidet.

8. Vorrichtung nach einem der Ansprüche 5 bis 7, wobei das Metall aus einem der Elemente aus der Liste bestehend aus Gold, Nickel und einer mehrschichtigen Gold-Nickel-Schichtstruktur ausgewählt ist.

9. Vorrichtung nach einem der Ansprüche 1 bis 8, wobei die Elektroden durch einen Graben voneinander getrennt sind, welcher einen Abstand von weniger als oder im Wesentlichen gleich 100 Nanometer zwischen den beiden Elektroden festlegt.

10. Vorrichtung nach einem der Ansprüche 1 bis 9, wobei die Elektroden durch einen Graben voneinander getrennt sind und gegenüberliegend mit einem linearen Abstand zwischen einigen Mikrometern und einigen Metern eingestellt werden.

11. Vorrichtung nach einem der Ansprüche 1 bis 10, wobei die beiden Elektroden unterschiedliche Höhen aufweisen, die senkrecht zu einer gemeinsamen Hauptebene der beiden Elektroden definiert werden.

12. Vorrichtung nach einem der Ansprüche 1 bis 11, die geeignet ist, um als eine photoelektrische Vorrichtung betrieben zu werden, und die in der Lage ist, photoelektrische Eigenschaften ausgehend von einer vorbestimmten Temperatur zu verändern, wobei die Partikel mit einem Zustandsübergang des Elektronenspins aus Partikeln mit einem Zustandsübergang des Elektronenspins ausgewählt sind, der durch die Temperatur gesteuert wird, wobei der Zustandsübergang des Elektronenspins bei der angegebenen Temperatur herum erfolgt.

13. Verfahren zur Herstellung einer Vorrichtung nach einem der vorhergehenden Ansprüche, umfassend die aufeinander folgenden folgenden Schritte:
a) Bereitstellen von zwei Metallelektroden auf einem Substrat, die voneinander durch einen Graben getrennt sind,
b) Ablagern von mindestens einem Partikel mit einem Zustandsübergang des Elektronenspins, welcher durch die Temperatur gesteuert wird, sodass es im gleichzeitigen Kontakt mit den beiden Elektroden liegt, in Form einer lokalisierten Abscheidung einer flüssigen Lösung, umfassend das Partikel in ionischer Lösung, gefolgt von einer Verdampfung der flüssigen Lösung, die das Partikel auf der Vorrichtung lässt, wobei das Partikel vom ionischen Typ ist, umfassend ein Übergangsmetall, das eine kationische Ladung trägt, wobei die Elektroneutralität der flüssigen Lösung durch ein anionisches Gegenion gewährleistet wird.

14. Verfahren nach Anspruch 13, umfassend, nach dem Schritt b), das Anlegen einer Spannung zwischen den beiden Elektroden, die hoch genug ist, um die Zugangswiderstände zwischen den Elektroden und dem Partikel zu reduzieren, aber die niedrig genug ist, um die Zerstörung des Partikels oder des Grabens, welcher die Elektroden trennt, zu vermeiden.

15. Verfahren nach Anspruch 14, wobei die angelegte Spannung zwischen 0,5 Volt und 5 Volt liegt.

16. Verfahren nach einem der Ansprüche 13 bis 15, wobei die Elektroden mindestens ein magnetisierbares Metall umfassen, und wobei vor dem Schritt b) vorgesehen ist:
- ein Schritt, in welchem das in Schritt b) abzulagernde Partikel teilweise mit einer Metallschicht abgedeckt wird, die magnetische Eigenschaften aufweist,
- und ein Schritt der Magnetisierung der Elektroden durch Anlegen eines Magnetfeldes auf Höhe der beiden Elektroden,
- und wobei der Schritt b) zwischen der Abscheidung der flüssigen Lösung und ihrer Verdampfung einen Schritt zur Anordnung der Partikel auf dem Graben, welcher die Elektroden trennt, mittels einer Anwendung eines Magnetfeldes auf Höhe der beiden Elektroden umfasst.

## Claims

1. Electrical device having two electrodes separated from one another, **characterized in that** at least one temperature controlled electronic spin-state transition particle is in direct contact with each of the two electrodes, the particle being of the ionic type and having a transition metal bearing a cationic charge.

2. Device according to claim 1, wherein the particle is based on a compound satisfying the formula:
[Fe(G)₃](X)ₙ
where G is a 1,2,4-triazole ligand with a substituent R on the nitrogen in position 4, indicated as R-Trz;
X represents at least one anion;
and n is calculated in such a way that the electroneutrality of the formula is respected.

3. Device according to claim 2, wherein substituent R is chosen from among the group composed of hydrogen and H₂N-, R₁-, HR₁N-, and R₁R₂N-compounds, where R₁ and R₂ are alkyl radicals.

4. Device according to any of claims 1 to 3, wherein the particle is a nanometric particle at least one of whose dimensions is comprised between 30 nm and 700 nm.

5. Device according to claim 4, wherein the particle is covered dissymmetrically with a layer of metal.

6. Device according to any of claims 1 to 5, suitable for functioning as a photoconductive device wherein the two electrodes are covered by the same metal.

7. Device according to any of claims 1 to 6, suitable for functioning as a photovoltaic device, wherein one of the two electrodes is covered by a first metal and the other of the two electrodes is covered by a second metal that is different from the first metal.

8. Device according to any of claims 5 to 7, wherein the metal is chosen from among one of the elements on the list consisting of gold, nickel, and a multilayer gold-nickel structure.

9. Device according to any of claims 1 to 8, wherein the electrodes are separated by a trench imposing a distance that is less than or appreciably equal to 100 nanometers between the two electrodes.

10. Device according to any of claims 1 to 9, wherein the electrodes are separated by a trench and opposite one another across a linear distance comprised between a few micrometers and a few meters.

11. Device according to any of claims 1 to 10, wherein the heights of the two electrodes, defined perpendicularly to a principal plane shared by the two electrodes, are different from one another.

12. Device according to any of claims 1 to 11, suitable for functioning as a photoelectric device and suitable for changing photoelectric properties based on a predetermined temperature, wherein the electronic spin-state transition particles are chosen from among the temperature controlled electronic spin-state transition particles whose electronic spin-state transition occurs near the specified temperature.

13. Method for manufacturing a device according to any of the previous claims, having the following successive steps:
a) supply of two metallic electrodes on a substrate, separated from one another by a trench;
b) deposit of at least one temperature controlled electronic spin-state transition particle so that it is in direct simultaneous contact with both electrodes, in the form of the localized application of a liquid solution containing the particle in ionic solution, followed by evaporation of the liquid solution, leaving the particle on the device, the particle being of the ionic type containing a transition metal that bears a cationic charge, the electroneutrality of the liquid solution being assured by an anionic counterion.

14. Method according to claim 13 incorporating, after step b), the application of a voltage between the two electrodes that is sufficiently high to reduce the access resistances between the electrodes and the particle but sufficiently low to avoid destruction of the particle or the trench separating the electrodes.

15. Method according to claim 14 wherein the applied voltage is comprised between 0.5 and 5 volts.

16. Method according to any of claims 13 to 15 wherein the electrodes have at least one magnetizable metal and wherein it can be incorporated prior to step b):
- a step during which the particle to be deposited in step b) is partially covered with a layer of metal having magnetic properties;
- and a step involving magnetization of the electrodes by means of the application of a magnetic field at the two electrodes, and wherein step b) includes, between deposition of the liquid solution and its evaporation, a step involving organization of the particles at the trench separating the electrodes by means of the application of a magnetic field at the two electrodes.
